# EUROPEAN PATENT APPLICATION

(11) **EP 4 704 084 A1**
(43) Date of publication of application: **04.03.2026**
(21) Application number: 25194683.6
(22) Date of filing: 07.08.2025
(51) Int. Cl.: G11C 5/04

(54) **ACTIVE INFORMATION DISPLAY DYNAMIC MEMORY MODULE AND INFORMATION DISPLAY METHOD THEREOF**

(30) Priority: 29.08.2024 TW 113132528
(71) Applicant: V-Color Technology Inc., New Taipei City 231 (TW)
(72) Inventor: HO, Tien-Shun, New Taipei City (TW)
(74) Representative: M. Zardi & Co S.A.

(57) **Abstract**

An active information display dynamic memory module is disclosed. The active information display dynamic memory module involves a microcontroller unit; a serial presence detect hub, electrically connected to the microcontroller unit; and a display panel, electrically connected to the microcontroller unit. Thereby, for DRAM modules under the JEDEC specification, new functional circuits on the circuit layout on the circuit carrier board is designed through designing customized microcontroller units. Through firmware design, the microcontroller unit is electrically connected to the serial presence detect hub and the display panel and controlled to actively display the specification and information of memory modules of different models.

## Description

### BACKGROUND

### Technical Field

The present invention relates to the technical field of memory, in particular to an active information display dynamic memory module and an information display method thereof.

### Description of Related Art

Current memory modules include Double Data Rate (DDR) memory architecture, Compression Attached Memory Module version 2 (CAMM2) architecture and Solid-State Drive (SSD) architecture. The memory module is usually installed on the motherboard and inside the computer host or laptop. In order to understand the status and related information of the memory module, user must read the memory module information through software, or enter the BIOS (Basic Input/Output System) through firmware to see the related information of the memory module. Therefore, it is impossible to know the status of the memory module without software execution and without the BIOS environment, and only passive data display can be performed, which is very inconvenient.

### SUMMARY

A primary objective of the present invention is to provide an active information display dynamic memory module. For DRAM (Dynamic Random-Access Memory) modules under the JEDEC (Joint Electron Device Engineering Council) specification, by designing a customized control IC (such as a microcontroller unit (MCU)), design a new functional circuit in the circuit layout of the circuit carrier board, and through firmware design, the control IC is electrically connected to the serial presence detection hub (SPDhub) and the display panel and controlled to achieve active display of specifications and information of memory modules of different architectures.

In order to achieve the aforementioned objective, the present invention provides an active information display dynamic memory module. The active information display dynamic memory module includes a microcontroller unit; a serial presence detect hub, electrically connected to the microcontroller unit; and a display panel, electrically connected to the microcontroller unit.

In some embodiments, the active information display dynamic memory module further comprises a circuit carrier board. The microcontroller unit, the serial presence detect hub and the display panel are installed on the circuit carrier board.

In some embodiments, the active information display dynamic memory module is a double data rate (DDR) memory architecture, the serial presence detect hub is mounted on a rear surface of the circuit carrier board, the microcontroller unit is mounted on a front surface of the circuit carrier board, and the display panel is mounted on the rear surface of the circuit carrier board.

In some embodiments, the active information display dynamic memory module further comprises a first heat sink. The heat sink is correspondingly disposed above the rear surface of the circuit carrier board.

In some embodiments, the first heat sink has a first window corresponding to the display panel so that the display panel is exposed.

In some embodiments, the active information display dynamic memory module is a compressed connected memory module (CAMM2) architecture, the serial presence detect hub, the microcontroller unit and the display panel are mounted on the same surface of the circuit carrier board.

In some embodiments, the circuit carrier board has an extended blank portion, and the display panel is mounted on the extended blank portion.

In some embodiments, the active information display dynamic memory module further comprises a second heat sink. The second heat sink is correspondingly disposed above the surface of the circuit carrier board on which the serial presence detect hub, the microcontroller unit and the display panel are installed.

In some embodiments, the second heat sink has a second window corresponding to the display panel so that the display panel is exposed.

In some embodiments, the display panel is an organic light-emitting diode (OLED) display panel.

In order to achieve the aforementioned objective, the present invention provides an information display method of an active information display dynamic memory module including a microcontroller unit, a serial presence detect hub, and a display panel. When the active information display dynamic memory module is electrically connected to a motherboard, the method includes: causing the microcontroller unit to obtain data stored in the serial presence detect hub through the motherboard; and causing the microcontroller unit, after obtaining the data, to control the display panel to actively display the data.

In order to make the above objectives, features and advantages of the present invention more obvious and understandable, the specific embodiments listed in the drawings are described in detail below.

### BRIEF DESCRIPTION OF THE DRAWINGS

Aspects of the present invention are best understood from the following detailed description when read with the accompanying figures. It is noted that, in accordance with the standard practice in the industry, various features are not drawn to scale. In fact, the dimensions of the various features may be increased or reduced for clarity of discussion.
FIG. 1 is a block diagram of an active information display dynamic memory module according to the present invention.
FIG. 2 is an exploded schematic rear view of a first embodiment of the active information display dynamic memory module according to the present invention.
FIG. 3 is a partially exploded schematic front view of the first embodiment of the active information display dynamic memory module according to the present invention.
FIG. 4 is a partial assembly diagram of the first embodiment of the active information display dynamic memory module according to the present invention.
FIG. 5 is a schematic diagram of a first heat sink correspondingly used in the first embodiment of the active information display dynamic memory module according to the present invention.
FIG. 6 is a partially exploded schematic diagram of a second embodiment of the active information display dynamic memory module according to the present invention.
FIG. 7 is a schematic assembly diagram of the second embodiment of the active information display dynamic memory module according to the present invention.
FIG. 8 is a schematic diagram of a second heat sink correspondingly used in the second embodiment of the active information display dynamic memory module according to the present invention.
FIG. 9 is a schematic assembly diagram of a third embodiment of the active information display dynamic memory module according to the present invention.

### DETAILED DESCRIPTION

In the following description, certain specific details are set forth in order to provide a thorough understanding of various aspects of the disclosed subject matter. However, the disclosed subject matter may be practiced without these specific details. In some instances, well-known structures and methods of power delivery comprising embodiments of the subject matter disclosed herein have not been described in detail to avoid obscuring the descriptions of other aspects of the present invention.

Unless the context requires otherwise, throughout the specification and claims that follow, the word "comprise," "have," "include," and variations thereof, such as "comprises," "comprising," "having," "including" are to be construed in an open, inclusive sense, that is, as "including, but not limited to."

Reference throughout the specification to "one embodiment" or "an embodiment" means that a particular feature, structure, or characteristic described in connection with the embodiment is included in at least one embodiment. Thus, the appearance of the phrases "in one embodiment" or "in an embodiment" in various places throughout the specification are not necessarily all referring to the same aspect. Furthermore, the particular features, structures, or characteristics may be combined in any suitable manner in one or more aspects of the present invention.

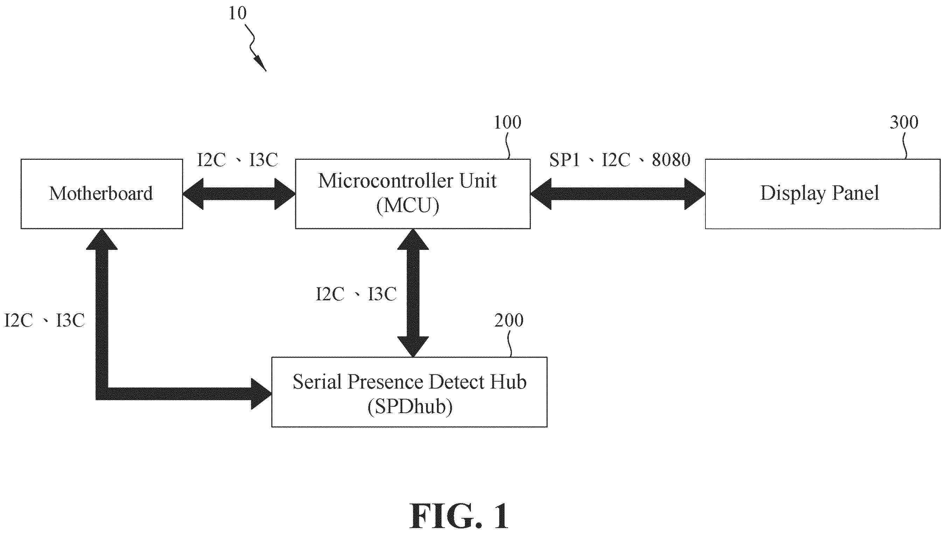

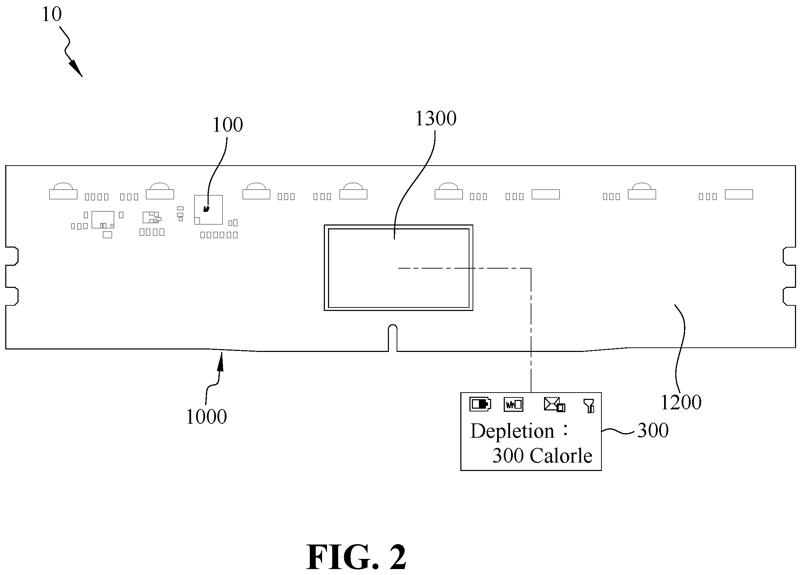

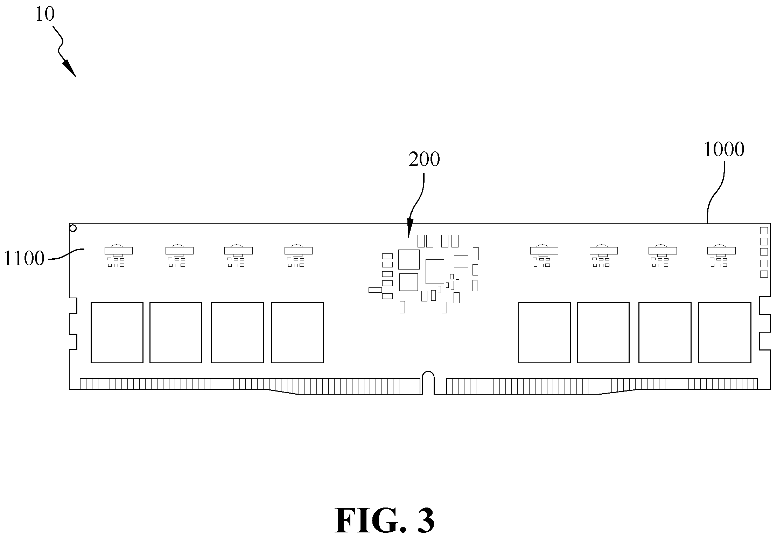

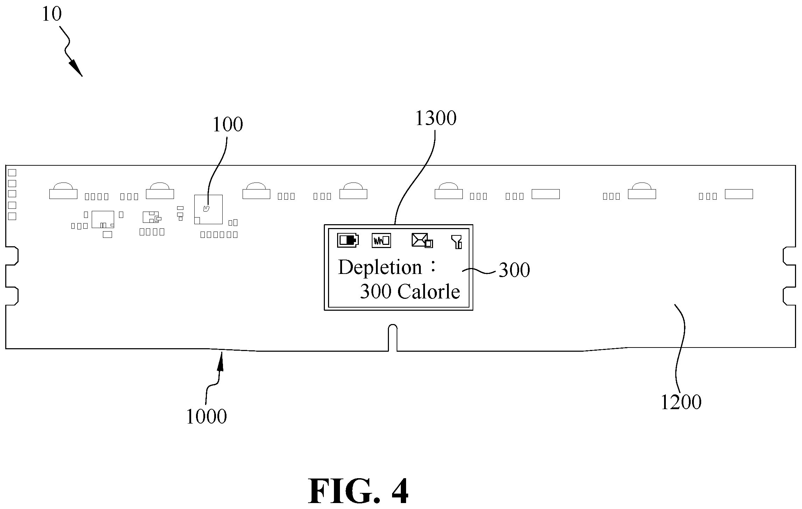

FIG. 1 is a block diagram of an active information display dynamic memory module according to the present invention. FIG. 2 is an exploded schematic rear view of a first embodiment of the active information display dynamic memory module according to the present invention. FIG. 3 is a partially exploded schematic front view of the first embodiment of the active information display dynamic memory module according to the present invention. FIG. 4 is a partial assembly diagram of the first embodiment of the active information display dynamic memory module according to the present invention.

Please refer to FIG. 1, the active information display dynamic memory module 10 of a first embodiment according to the present invention includes a microcontroller unit (MCU) 100, a serial presence detect hub (SPDhub) 200 and a display panel 300. In some embodiments, the microcontroller unit 100 and the serial presence detect hub 200 may be in the form of an integrated circuit (IC). That is, the microcontroller unit 100 may be a microcontroller unit integrated circuit (MCU IC), and the serial presence detect hub 200 may be a serial presence detect hub integrated circuit (SPDhub IC), but it is not limited thereto.

The microcontroller unit 100 may be a general microcontroller unit or a customized microcontroller unit. In other words, it may be replaced according to design requirements.

The serial presence detect hub 200 may be electrically connected to the microcontroller unit 100. In some embodiments, the serial presence detect hub 200 may be communicated with the microcontroller unit 100 through an I2C (inter-integrated circuit) interface or an I3C (improved inter-integrated circuit) interface. The microcontroller unit 100 may read the data in the serial presence detect hub 200 through the I2C interface or the I3C interface (for example, bus), including the memory module clock (or frequency), delay clock (Timing), capacity, voltage, temperature, but it is not limited thereto.

In some embodiments, the serial presence detect hub 200 and the microcontroller unit 100 may be communicated with the motherboard through an I2C interface or an I3C interface. The motherboard can read the data stored in the serial presence detect hub 200 through the I2C interface or the I3C interface, including memory module clock (or frequency), delay clock (Timing), capacity, voltage, and temperature, but is not limited thereto, and then transmit it to the microcontroller unit 100 via the I2C interface or the I3C interface.

The display panel 300 may be electrically connected to the microcontroller unit 100. In some embodiments, the display panel 300 may be communicated with the microcontroller unit 100 through one of an I2C interface, SPI (Serial Peripheral Interface), and an 8080 interface. In some embodiments, the display panel 300 may be an organic light-emitting diode (OLED) display panel, but it is not limited thereto. The display panel 300 may actively display various information and play dynamic short films, trademark dynamic graphics, brand dynamic graphics, etc. The various information may be the aforementioned data stored in the serial presence detect hub 200, including memory module clock (or frequency), delay clock (Timing), capacity, voltage, temperature, but it is not limited thereto.

In some embodiments, the active information display dynamic memory module 10 of the present invention further includes a circuit carrier board 1000. The microcontroller unit 100, the serial presence detect hub 200, and the display panel 300 may be mounted on the circuit carrier board 1000. In this embodiment, the active information display dynamic memory module 10 may be a double data rate (DDR) memory architecture, which is installed upright through a standing slot (not shown). For example, the DDR memory architecture includes the existing generations of DDR, DDR2, DDR3, DDR4, and DDR5, but t2his embodiment uses DDR5 UDIMM (unbuffered dual in-line memory module, unbuffered dual in-line memory module) / CUDIMM (Clocked Unbuffered DIMM) specifications as an example. The serial existence detect hub 200 may be installed on a rear surface 1200 of the circuit carrier board 1000, the microcontroller unit 100 can be installed on a front surface 1100 of the circuit carrier board 1000, and the display panel 300 may be installed in an adhesive area 1300 on the rear surface 1200 of the circuit carrier board 1000.

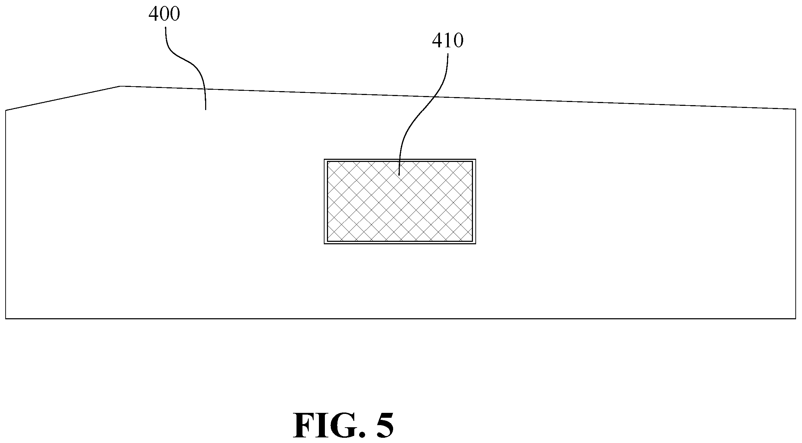

FIG. 5 is a schematic diagram of a first heat sink correspondingly used in the first embodiment of the active information display dynamic memory module according to the present invention.

Please refer to FIG. 5, a first heat sink 400 may be disposed correspondingly in the active information display dynamic memory module 10 of the first embodiment. The first heat sink 400 may be correspondingly disposed above the rear surface 1200 of the circuit carrier board 1000. In some embodiments, the first heat sink 400 may have a first window 410 corresponding to the display panel 300 so that the display panel 300 is exposed, whereby various information displayed on the display panel 300 may be directly viewed from the outside.

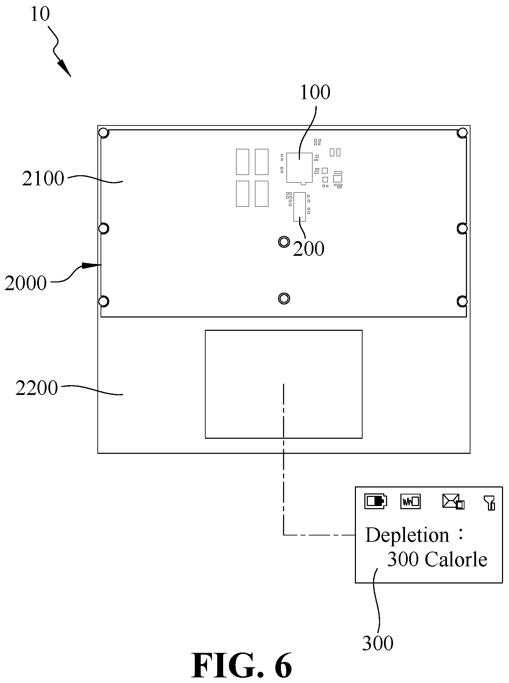

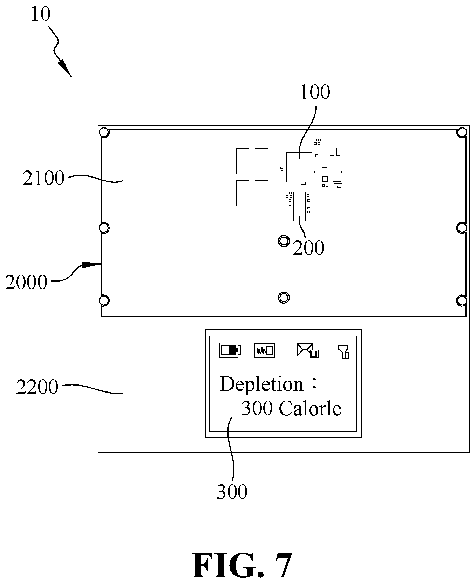

FIG. 6 is a partially exploded schematic diagram of a second embodiment of the active information display dynamic memory module according to the present invention. FIG. 7 is a schematic assembly diagram of the second embodiment of the active information display dynamic memory module according to the present invention. The structural blocks of the active information display dynamic memory module of the second embodiment are substantially the same as the structural blocks of the aforementioned active information display dynamic memory module of the first embodiment, the differences therebetween will be explained in the following paragraphs, and the same components are represented by the same numeral.

Please refer to FIG. 1, FIG. 6 and FIG. 7, the active information display dynamic memory module 10 of the second embodiment includes a microcontroller unit (MCU) 100, a serial presence detect hub (SPDhub) 200 and a display panel 300. In some embodiments, the microcontroller unit 100 and the serial presence detect hub 200 may be in the form of an integrated circuit (IC). That is, the microcontroller unit 100 may be a microcontroller unit integrated circuit (MCU IC), and the serial presence detect hub 200 may be a serial presence detect hub integrated circuit (SPDhub IC), but it is not limited thereto.

The microcontroller unit 100 may be a general microcontroller unit or a customized microcontroller unit. In other words, it may be replaced according to design requirements.

The serial presence detect hub 200 may be electrically connected to the microcontroller unit 100. In some embodiments, the serial presence detect hub 200 may be communicated with the microcontroller unit 100 through an I2C (inter-integrated circuit) interface or an I3C (improved inter-integrated circuit) interface. The microcontroller unit 100 may read the data in the serial presence detect hub 200 through the I2C interface or the I3C interface (for example, bus), including the memory module clock (or frequency), delay clock (Timing), capacity, voltage, temperature, but it is not limited thereto.

In some embodiments, the serial presence detect hub 200 and the microcontroller unit 100 may be communicated with the motherboard through an I2C interface or an I3C interface. The motherboard can read the data stored in the serial presence detect hub 200 through the I2C interface or the I3C interface, including memory module clock (or frequency), delay clock (Timing), capacity, voltage, and temperature, but is not limited thereto, and then transmit it to the microcontroller unit 100 via the I2C interface or the I3C interface.

The display panel 300 may be electrically connected to the microcontroller unit 100. In some embodiments, the display panel 300 may be communicated with the microcontroller unit 100 through one of an I2C interface, SPI (Serial Peripheral Interface), and an 8080 interface. In some embodiments, the display panel 300 may be an organic light-emitting diode (OLED) display panel, but it is not limited thereto. The display panel 300 may actively display various information and play dynamic short films, trademark dynamic graphics, brand dynamic graphics, etc. The various information may be the aforementioned data stored in the serial presence detect hub 200, including memory module clock (or frequency), delay clock (Timing), capacity, voltage, temperature, but it is not limited thereto.

In some embodiments, the active information display dynamic memory module 10 of the present invention further includes a circuit carrier board 2000. The microcontroller unit 100, the serial presence detect hub 200, and the display panel 300 may be mounted on the circuit carrier board 2000. In this embodiment, the active information display dynamic memory module 10 may be a compression attached memory module architecture. For example, the compression attached memory module may include CAMM and CAMM2, and this embodiment takes CAMM2 as an example for explanation. The serial presence detect hub 200, the microcontroller unit 100, and the display panel 300 may be mounted on the same surface 2100 of the circuit carrier board 2000. In some embodiments, the circuit carrier board 2000 of this embodiment may have an extended blank portion 2200, and the display panel 300 may be installed on an adhesive area 2300 at the extended blank portion 2200.

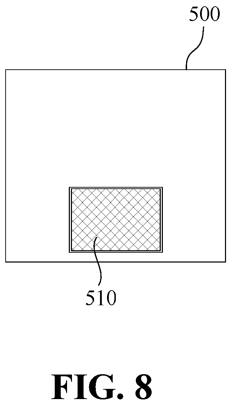

FIG. 8 is a schematic diagram of a second heat sink correspondingly used in the second embodiment of the active information display dynamic memory module according to the present invention.

Please refer to FIG. 8, a second heat sink 500 may be disposed in the active information display dynamic memory module 10 of the second embodiment. The second heat sink 500 may be correspondingly disposed above the surface 2100 of the circuit carrier board 2000 on which the serial presence detect hub 200, the microcontroller unit 100 and the display panel 300 are installed. In some embodiments, the second heat sink 500 may have a second window 510 corresponding to the display panel 300 so that the display panel 300 is exposed, whereby various information displayed on the display panel 300 may be directly viewed from the outside.

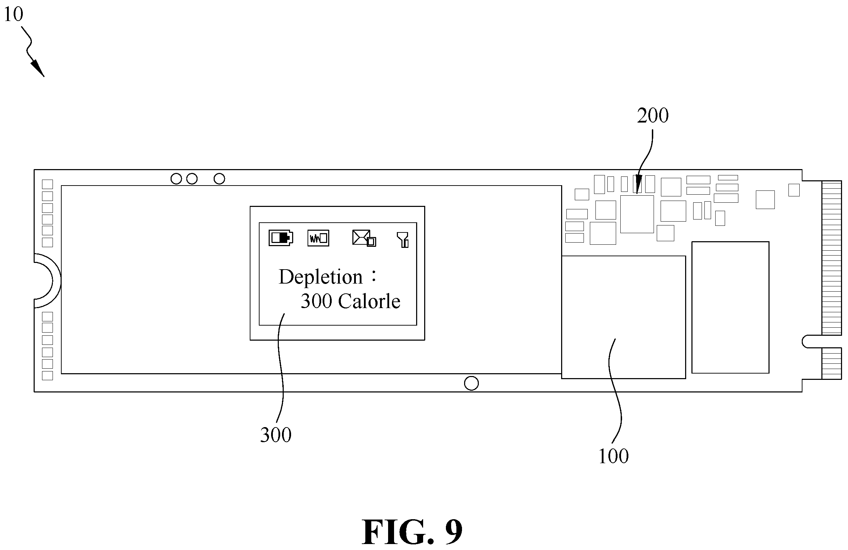

FIG. 9 is a schematic assembly diagram of a third embodiment of the active information display dynamic memory module according to the present invention. In addition, please refer to FIG. 9, the active information display dynamic memory module 10 may be a solid-state drive (SSD) architecture and is configured corresponding to each component of the structural block diagram of FIG. 1, but it is not limited thereto. Since the structural blocks of the active information display dynamic memory module of the third embodiment are substantially the same as the structural blocks of the active information display dynamic memory module of the second embodiment, their functions and structures will not be described again.

In conclusion, the active information display dynamic memory module 10 of the present invention is designed for the DRAM module under the JEDEC specification by designing a customized control IC (for example, a microcontroller unit (MCU) 100). Design a new functional circuit in the circuit layout on the circuit carrier board 1000 or the circuit carrier board 2000, and the control IC (for example, the microcontroller unit (MCU) 100) is electrically connected to the serial presence detect hub 200 and the display panel 300 and controlled through firmware design to actively display specifications and information of memory modules of different architectures.

## Claims

1. An active information display dynamic memory module (10), comprising:
a microcontroller unit (100);
a serial presence detect hub (200), electrically connected to the microcontroller unit (100); and
a display panel (300), electrically connected to the microcontroller unit (100).

2. The active information display dynamic memory module (10) according to claim 1, further comprising a circuit carrier board (1000), the microcontroller unit (100), the serial presence detect hub (200) and the display panel (300) are installed on the circuit carrier board (1000).

3. The active information display dynamic memory module (10) according to claim 2, wherein the active information display dynamic memory module (10) is a double data rate (DDR) memory architecture, the serial presence detect hub (200) is mounted on a rear surface (1200) of the circuit carrier board (1000), the microcontroller unit (100) is mounted on a front surface (1100) of the circuit carrier board (1000), and the display panel (300) is mounted on the rear surface (1200) of the circuit carrier board (1000).

4. The active information display dynamic memory module (10) according to claim 3, further comprising a first heat sink (400), correspondingly disposed above the rear surface (1200) of the circuit carrier board (1000).

5. The active information display dynamic memory module (10) according to claim 4, wherein the first heat sink (400) has a first window (410) corresponding to the display panel (300) so that the display panel (300) is exposed.

6. The active information display dynamic memory module (10) according to any of claims 2 to 5, wherein the active information display dynamic memory module (10) is a compressed connected memory module (CAMM2) architecture, the serial presence detect hub (200), the microcontroller unit (100) and the display panel (300) are mounted on the same surface (2100) of the circuit carrier board (2000).

7. The active information display dynamic memory module (10) according to any of claims 2 to 6, wherein the circuit carrier board (2000) has an extended blank portion (2200), and the display panel (300) is mounted on the extended blank portion (2200).

8. The active information display dynamic memory module (10) according to claim 6 or 7, further comprising a second heat sink (500), correspondingly disposed above the surface (2100) of the circuit carrier board (2000) on which the serial presence detect hub (200), the microcontroller unit (100) and the display panel (300) are installed.

9. The active information display dynamic memory module (10) according to claim 8, wherein the second heat sink (500) has a second window (510) corresponding to the display panel (300) so that the display panel (300) is exposed.

10. The active information display dynamic memory module (10) according to any preceding claim, wherein the display panel (300) is an organic light-emitting diode (OLED) display panel.

11. An information display method of an active information display dynamic memory module (10) comprising a microcontroller unit (100), a serial presence detect hub (200), and a display panel (300), **characterized in that** when the active information display dynamic memory module (10) is electrically connected to a motherboard, the method comprises:
causing the microcontroller unit (100) to obtain data stored in the serial presence detect hub (200) through the motherboard; and
causing the microcontroller unit (100), after obtaining the data, to control the display panel (300) to actively display the data.
